# EUROPÄISCHE PATENTSCHRIFT

(11) **EP 2 979 525 B1**
(45) Veröffentlichungstag und Bekanntmachung des Hinweises auf die Patenterteilung: **08.02.2017**
(21) Anmeldenummer: 14711186.8
(22) Anmeldetag: 11.03.2014
(51) Int. Cl.: H05K 7/14, F27B 7/42, F27D 21/00

(54) **ELEKTRONIKSCHUTZGEHÄUSE ZUR AUFNAHME EINER ELEKTRONIK**
ELECTRONICS PROTECTION HOUSING TO ACCOMMODATE AN ELECTRONICS SYSTEM
BOÎTIER DE PROTECTION DE SYSTÈME ÉLECTRONIQUE DESTINÉ À RECEVOIR UN SYSTÈME ÉLECTRONIQUE

(30) Priorität: 26.03.2013 EP 13161049
(43) Veröffentlichungstag der Anmeldung: 03.02.2016
(73) Patentinhaber: Primetals Technologies Austria GmbH, 4031 Linz (AT)
(72) Erfinder: KUEHAS, Thomas, A-4222 Luftenberg (AT); HARTL, Manuel, A-4172 St. Johann am Wimberg (AT); HARTL, Franz, A-4720 Kallham (AT); ROHRHOFER, Andreas, A-4020 Linz (AT); WEINZINGER, Michael, A-4020 Linz (AT); LEHOFER, Martin, A-4050 Traun (AT)
(74) Vertreter: Metals@Linz
(86) Internationale Anmeldenummer: PCT/EP2014/054641
(87) Internationale Veröffentlichungsnummer: WO 2014/154474

(56) Entgegenhaltungen:
- EP-A1- 2 336 695
- WO-A1-2011/101138
- DE-A1-102008 014 712
- US-A1- 2012 118 629

## Beschreibung

Die Erfindung betrifft ein Elektronikschutzgehäuse zur Aufnahme einer Elektronik.

Eine derartige Vorrichtung kommt beispielsweise bei elektronischen Bauteilen in Heißbereichen oder an Körpern mit extremer Temperaturabstrahlung zum Einsatz. Beispielsweise kann ein derartiges Elektronikschutzgehäuse bei metallurgischen Behältnissen, wie zum Beispiel Konvertern, zum Schutz einer Elektronik eingesetzt werden, welche physikalische Beobachtungsgrößen des im Konverter befindlichen flüssigen Roheisens oder Stahlbades erfasst. Neben Anwendungen im Stahlwerksumfeld kann ein derartiges Elektronikschutzgehäuse auch bei der Herstellung von Zement, beispielsweise mittels eines Drehrohrofens, oder bei anderen industriellen Prozessen, welche bei hoher Temperatur ablaufen, zum Einsatz kommen.

Ein Elektronikschutzgehäuse für Awwendungen in Einsatzgebieten mit stark erhöhter Umgebungstemperatur wird in dem Dokument WO2011/101138A1 offenbart.

Das Dokument EP2336695A1 offenbart eine metallurgische Anlage mit einem eine Elektronik aufnehmendem Gehäuse. Das Dokument DE102008014712A1 offenbart eine in der Automatisierungstechnik eingesetzte Messeinrichtung die teilweise aus nachwachsenden Rohstoffen besteht.

Der Erfindung liegt die Aufgabe zugrunde, ein Elektronikschutzgehäuse bereitzustellen, welches eine darin befindliche Elektronik zuverlässig vor Hitze oder heißen Flüssigkeiten bzw. Feststoffen schützt.

Diese Aufgabe wird durch ein Elektronikschutzgehäuse der eingangs genannten Art dadurch gelöst, dass das Elektronikschutzgehäuse einen inneren Gehäuseteil, mittels dem die Elektronik zumindest teilweise umschließbar ist, und zumindest einen äußeren Gehäuseteil aufweist, der den inneren Gehäuseteil zumindest teilweise umschließt und der mittels einer mechanisch lösbaren Verbindung am inneren Gehäuseteil befestigbar ist, wobei der zumindest eine äußere Gehäuseteil zumindest eine Lage mit einem nachwachsenden Rohstoff aufweist, wobei der innere Gehäuseteil zumindest eine Lage mit einem Material mit einer Temperaturbeständigkeit von mindestens bis 150 °C aufweist. Weiterhin wird diese Aufgabe durch ein System nach Anspruch 17 gelöst.

Der zumindest eine äußere Gehäuseteil kann dabei als ein Verschleißteil bzw. eine Verschleißschale angesehen werden, welches ähnlich einer Zwiebelschale auch mehrere Lagen mit einem nachwachsenden Rohstoff aufweisen kann. Vorzugsweise wird der zumindest eine äußere Gehäuseteil bzw. der innere Gehäuseteil so ausgeführt, dass ein einfacher Austausch in möglichst kurzer Zeit durchgeführt werden kann. Hierfür kann die mechanisch lösbare Verbindung zum Beispiel als eine Steckverbindung oder eine Schraubverbindung ausgeführt sein. Diese Verbindung kann beispielsweise in den zumindest einen äußeren Gehäuseteil und/oder den inneren Gehäuseteil eingearbeitet sein.

Besonders gute Ergebnisse lassen sich erzielen, wenn der zumindest eine äußere Gehäuseteil bzw. die Lage mit einem nachwachsenden Rohstoff derart bearbeitet wurde, dass der zumindest eine äußere Gehäuseteil bzw. die Lage verbesserte Flammwiderstands- und/oder thermische Isoliereigenschaften aufweisen. Hierzu kann beispielsweise eine geeignete Imprägnierung verwendet werden.

Durch das bis mindestens 150 °C beständige Material bewahrt der innere Gehäuseteil die strukturelle Integrität des Elektronikschutzgehäuses und bietet gleichzeitig gute Isolationseigenschaften, insbesondere thermische bzw. elektrische Isolationseigenschaften. Weiterhin ermöglicht der innere Gehäuseteil einen mechanischen Schutz der Elektronik.

Durch das vorgeschlagene Elektronikschutzgehäuse ist es möglich, elektronische Bauteile in Heißbereichen bzw. an Körpern mit extremer Temperaturabstrahlung über längere Zeit sicher zu betreiben. Anstatt wie bisher eine Elektronik in derartigen Umwelteinflüssen nur für kurze Zeiten rein manuell bzw. periodisch in gewissen Abständen zu betreiben, erlaubt das vorgeschlagene Elektronikschutzgehäuse eine dauerhafte und kostengünstige Installation der Elektronik in rauen und heißen Umgebungen. Weil für den äußeren Gehäuseteil und/oder für den inneren Gehäuseteil sehr günstige Materialien verwendet werden können, ist die vorgeschlagene Lösung gleichzeitig kostengünstig.

Insgesamt ermöglicht das Elektronikschutzgehäuse insbesondere einen dauerhaften Betrieb einer Elektronik in der Nähe von metallurgischen Gefäßen und anderen Einsatzgebieten mit stark erhöhter Umgebungstemperatur. Dabei weisen der innere Gehäuseteil und die darin anordnete Elektronik eine längere Haltbarkeit auf. Gleichzeitig ist das Elektronikschutzgehäuse kostengünstig.

Die Nähe zu einem metallurgischen Gefäß ist beispielsweise gegeben, wenn nicht zuverlässig ausgeschlossen werden kann, dass Spritzer von flüssigem Metall oder dergleichen vom Gefäß auf das Elektronikschutzgehäuse gelangen, dass vom Gefäß herrührende Infrarot-Strahlung auf das Elektronikschutzgehäuse einwirkt oder dass eine heiße Abgas- oder Rauchströmung vom Gefäß auf das Elektronikschutzgehäuse einwirkt. Insbesondere liegt eine stark erhöhte Umgebungstemperatur vor, wenn das Elektronikschutzgehäuse zumindest teilweise bzw. zumindest abschnittsweise einer Temperatur von zumindest 150 °C, insbesondere zumindest 200 °C, ausgesetzt ist. Der dauerhafte Betrieb soll dabei so verstanden werden, dass die Elektronik über längere Zeit, insbesondere mehrere Tage, in den erläuterten Umgebungsbedingungen betrieben werden kann. Hierzu kann insbesondere ein gelegentlicher Austausch des zumindest einen äußeren Gehäuseteils erforderlich sein, sobald dieses aufgezehrt bzw. verschlissen ist.

Bei einer vorteilhaften Ausgestaltung der Erfindung sind der zumindest eine innere Gehäuseteil und der zumindest eine äußere Gehäuseteil zumindest abschnittsweise für Funkwellen zur drahtlosen Kommunikation durchlässig.

Somit kann das Elektronikschutzgehäuse derart ausgestaltet werden, dass die darin befindliche Elektronik drahtlos mit außerhalb des Elektronikschutzgehäuses angeordneten Kommunikationsteilnehmern kommunizieren kann. Insbesondere bei einem bewegten bzw. ortsveränderbaren Elektronikschutzgehäuse bzw. einer derartigen Elektronik sind Lösungen mit einer drahtlosen Kommunikation oftmals bisher nicht realisierbar. Dies liegt daran, dass für Elektronikschutzgehäuse bisher oftmals Metallgehäuse verwendet wurden, so dass anstatt einer drahtlosen Kommunikation eine Datenübermittlung mit Hilfe von Schleifringen, Drehdurchführungen, Schleppkabel und ähnlichen, kabelgebundenen Vorrichtungen realisiert wurde. Das Elektronikschutzgehäuse gemäß dieser vorteilhaften Ausgestaltung weist hingegen zumindest einen äußeren Gehäuseteil und zumindest einen inneren Gehäuseteil auf, welche zumindest abschnittsweise für Funkwellen durchlässig sind, so dass eine drahtlose Kommunikation ermöglicht wird. Daher können die genannten, kabelgebundenen Kommunikationsmittel eingespart werden, was einen Kostenvorteil darstellt und weniger Wartungsaufwand erfordert.

Bei einer weiteren vorteilhaften Ausgestaltung der Erfindung ist innerhalb des äußeren Gehäuseteils und/oder innerhalb des inneren Gehäuseteils ein Schutzgas vorgesehen. Das Schutzgas kann beispielsweise eines oder mehrerer Edelgase umfassen, wobei beispielsweise auch Kohlenstoffdioxid und/oder Helium bzw. Gemische der genannten Gase zum Einsatz kommen können. Durch das Schutzgas kann der Schutz der Elektronik weiter verbessert werden.

Bei einer weiteren vorteilhaften Ausgestaltung der Erfindung weist die zumindest eine Lage mit einem nachwachsenden Rohstoff Holz, Holzschaum, Pappe, Karton, einen Holzfaserverbundwerkstoff oder ein Gemisch zumindest zweier dieser Stoffe auf.

Holzschaum kann beispielsweise ausgehend von Holzsägespänen oder Zellulose hergestellt werden, wobei Getreidemehl zugesetzt werden kann. Zum Aufschäumen wird dabei ein Treibmittel verwendet, wie zum Beispiel Hefe, wobei der Holzschaum schließlich durch Backen der verwendeten Holzbestandteile mit dem zugesetzten Treibmittel erhalten wird. Optional kann dem Holzschaum auch ein Epoxidharz zugesetzt werden.

Dabei kann der jeweilige nachwachsenden Rohstoff bzw. das Gemisch derart bearbeitet sein, dass er sehr gute Flammwiderstands- und Isoliereigenschaften aufweist, beispielsweise indem der Stoff zu einem besonders dichten Material verpresst wurde und/oder mit einer flammwidrigen bzw. elektrisch isolierenden Imprägnierung oder Beschichtung versehen wird. Beispielsweise können auch verleimte Schichtholzbretter (cross laminated timber, kurz CLT) eingesetzt werden, welche als besonders feuerfeste Tragebalken aus dem Bauwesen bekannt sind und feuerbeständiger als viele andere Baustoffe, insbesondere viele Stahlsorten, sind.

Von Vorteil ist bei den genannten nachwachsenden Rohstoffen, dass sie sehr kostengünstig verfügbar sind, so dass ein verschlissenes äußeres Gehäuseteil sehr kostengünstig ersetzt werden kann. Außerdem weisen diese Rohstoffe eine besonders vorteilhafte Klimabilanz auf, da sie CO2-neutral sind.

Bei einer weiteren vorteilhaften Ausgestaltung der Erfindung weist die zumindest eine Lage mit dem Material mit einer Temperaturbeständigkeit von mindestens bis 150 °C Polytetrafluorethylen, Polyphenylensulfid, Silikon-Kautschuk, Polyimid, Ethylen-Propylen-Copolymer, Cyclo-Olefin-Copolymer, Polyetherimid, Polyethersulfon, Polyhydroxyalkanoat, Polyhydroxybutyrat, Polysulfon, oder ein Gemisch zumindest zweier dieser Stoffe auf.

Die genannten Kunststoffe weisen eine gute Temperaturbeständigkeit auf, so dass sie bei der Verwendung im inneren Gehäuseteil das Gehäuse zuverlässig vor Hitze bzw. heißen Flüssigkeiten oder Feststoffen schützen können. Dies wird dadurch erreicht, dass die entsprechende Kunststofflage ihre Form und ihre physikalischen Eigenschaften, insbesondere ihre Isolationseigenschaften, beibehält. Bei Anwendungen mit besonders hohen Temperaturen können dabei insbesondere Silikon-Kautschuk mit einer Temperaturbeständigkeit bis 200 °C, Polyphenylensulfid (bis 240 °C), Polyimid (bis 280 °C), Ethylen-Propylen-Copolymer (bis 300 °C) und Polytetrafluorethylen (kurz PTFE, bis 350 °C) zum Einsatz kommen. Dabei ist PTFE dank seiner ausgesprochenen Hitzebeständigkeit, seiner guten Isolationseigenschaften, seiner guten chemischen Beständigkeit für den Einsatz unter widrigsten Bedingungen besonders geeignet. Darüber hinaus ist PTFE hydrophob, hart, zähe und gleichzeitig sehr kostengünstig.

Bei einer weiteren vorteilhaften Ausgestaltung der Erfindung ist zumindest eine Medienleitung vorgesehen, welche von außerhalb des Elektronikschutzgehäuses in das innere Gehäuseteil hinein führt und in welchem ein Medium fließen kann. Insbesondere kann die zumindest eine Medienleitung eine Medienleitung sein, die für den Betrieb der Anlage notwendig ist. Beispielsweise kann die Medienleitung durch das Elektronikschutzgehäuse hindurch geführt werden. In dieser Medienleitung kann ein Medium zur Kühlung fließen, wie beispielsweise Wasser, dass zur Kühlung der Anlage verwendet wird, oder gasförmige Medien, wie z.B. Sauerstoff oder andere Gase, die in der Anlage als Prozessgase oder Spülgase verwendet werden. Es ist auch vorstellbar, das Elektronikschutzgehäuse mit einer Medienleitung zu versorgen, deren alleiniger Zweck die Sicherstellung der Kühlung des Elektronikschutzgehäuses ist.

Insbesondere in einem Umfeld mit hoher Temperaturabstrahlung, wie beispielsweise Konvertern im Stahlwerksumfeld oder in Drehrohröfen bei der Zementherstellung, stellt die Kühlung der Elektronik ein großes Problem dar. Dieses Problem wird bisher oftmals durch einen aktiven Eingriff in schon vorhandene Mediennetze derart gelöst, dass dabei Medien verbraucht werden bzw. verloren gehen. Daher ist bisher oftmals eine Druckprüfung des Mediums bzw. der Medienleitung erforderlich. Bei der in das innere Gehäuseteil hinein geführten Medienleitung kann es sich dabei um eine schon vorhandene Medienleitung handeln, welche beispielsweise zur Kühlung des Konverters oder des Drehrohrofens verwendet wird. Von Vorteil ist dabei, dass das Elektronikschutzgehäuse an die Medienleitung angebracht werden kann und die Medienleitung gegenüber dem Elektronikschutzgehäuse fluiddicht ist, so dass einerseits ein Wärmetransport in das flüssige oder gasförmige Medium stattfinden kann, andererseits aber keine Medien aus der Leitung heraus verloren gehen. Gegenüber Lösungen, bei denen Medien verloren gehen, ergibt sich somit bei der Herstellung bzw. der Installation des Elektronikschutzgehäuses ein Kostenvorteil durch die entfallende Druckprüfung der Medienleitung sowie im laufenden Betrieb ein Kostenvorteil, weil kein Medium verloren geht. Dies bietet besonders große Vorteile bei einem Betrieb des Elektronikschutzgehäuses in einem explosiven Umfeld, da durch die Vermeidung eines Verlustes des Mediums ein Sicherheitsvorteil, insbesondere in Bezug auf Wasserstoff-Explosionen, gegeben ist.

Durch das Vorsehen der Durchleitung zumindest einer Medienleitung kann dabei die Temperaturbeständigkeit des Elektronikschutzgehäuses weiter erhöht werden. Als durchgeleitete Medien können beispielsweise flüssiger Stickstoff, flüssiges Argon, Kühlwasser, Öl, Luft oder ein Schutzgas zum Einsatz kommen.

Bei einer weiteren vorteilhaften Ausgestaltung der Erfindung weist das Elektronikschutzgehäuse einen ersten Kühlkörper auf, mit welchem die Elektronik thermisch verbindbar ist und an welchen die verbundene Elektronik Abwärme abgeben kann.

Der erste Kühlkörper erlaubt einen effizienten Abtransport der Abwärme der Elektronik und in das Elektronikschutzgehäuse von außen eingebrachter bzw. durchgestrahlter Wärme und ermöglicht daher eine verlängerte Betriebsdauer der Elektronik, da die Elektronik zuverlässig vor einer Überhitzung geschützt werden kann. Dies wird beispielsweise dadurch erreicht, dass besonders heiße Stellen bzw. Hot-Spots der Elektronik zuverlässig entwärmt werden. Vorzugsweise ist der erste Kühlkörper dabei aus einem wärmeleitfähigen Material, wie zum Beispiel Kupfer oder Aluminium.

Bei einer weiteren vorteilhaften Ausgestaltung der Erfindung ist die zumindest eine Medienleitung dabei derart am ersten Kühlkörper angeordnet, dass der erste Kühlkörper Abwärme an das Kühlmedium abgeben kann.

Die Anordnung der zumindest einen Medienleitung am ersten Kühlkörper ist dabei insbesondere derart, dass ein thermischer Kontakt zwischen beiden Elementen vorhanden ist. Dies stellt einen besonders effizienten Abtransport der Abwärme der Elektronik sicher, wodurch die Betriebsdauer der Elektronik stark erhöht werden kann. Gleichzeitig kann auch die Temperatur des inneren Gehäuseteils und/oder des zumindest einen äußeren Gehäuseteils verringert werden, so dass das Elektronikschutzgehäuse insgesamt, insbesondere der zumindest eine äußere Gehäuseteil, länger verwendet werden kann.

Bei einer weiteren vorteilhaften Ausgestaltung der Erfindung weist das Elektronikschutzgehäuse dabei einen zweiten Kühlkörper auf, wobei die zumindest eine Medienleitung derart am zweiten Kühlkörper angeordnet ist, dass der zweite Kühlkörper Abwärme an das Medium abgeben kann, wobei zwischen dem ersten Kühlkörper und dem zweiten Kühlkörper eine Isolierlage mit einem Kunststoff mit einer Temperaturbeständigkeit von mindestens bis 150 °C angeordnet ist.

Durch den zweiten Kühlkörper kann die Temperatur des inneren Gehäuseteils weiter verringert werden, wobei Isolierlage sicherstellt, dass die Abwärme der Elektronik nicht über den ersten Kühlkörper und den zweiten Kühlkörper schließlich an das restliche Elektronikschutzgehäuse abgegeben wird. Wenn der zweite Kühlkörper in thermischem Kontakt mit dem inneren Gehäuseteils und/oder dem zumindest einen äußeren Gehäuseteil ist und der jeweilige Gehäuseteil durch heiße Umgebungsbedingungen des Elektronikschutzgehäuses aufgeheizt wird bzw. heiß ist, kann somit auch wirkungsvoll verhindert werden, dass die Hitze von außerhalb des Elektronikschutzgehäuses über den zumindest einen äußeren Gehäuseteil und/oder den inneren Gehäuseteil und anschließend den zweiten Kühlkörper und den ersten Kühlkörper schließlich an die Elektronik geleitet wird. Somit bewirkt die Isolierlage, welche beispielsweise aus PTFE ist, eine wirkungsvolle thermische Trennung der beiden Kühlkörper, welche insgesamt in einer verlängerten Betriebsdauer der Elektronik bzw. des Elektronikschutzgehäuses resultiert.

Bei einer weiteren vorteilhaften Ausgestaltung der Erfindung weist das Elektronikschutzgehäuse ein Peltier-Element auf, mittels welchem die Elektronik versorgbar ist, wobei eine Seite des Peltier-Elementes mit der zumindest einen Medienleitung in thermischem Kontakt steht.

Durch den Anschluss der einen Seite des Peltier-Elementes mit der zumindest einen Medienleitung es möglich, mit dem Peltier-Element eine große Temperaturdifferenz abzugreifen, beispielsweise indem die andere Seite des Peltier-Elementes mit einem möglichst heißen Punkt innerhalb oder außerhalb des Elektronikschutzgehäuses in thermischem Kontakt steht. Für die andere Seite des Peltier-Elementes ist somit eine thermische Verbindung mit der Elektronik oder einer heißen Seitenfläche des Gehäuses besonders vorteilhaft. Durch den Anschluss an zwei Punkte mit einer Temperaturdifferenz erzeugt das Peltier-Element gemäß dem Seebeck-Effekt einen elektrischen Strom, mit dem die Elektronik versorgt werden kann.

Die Verwendung des Peltier-Elementes erlaubt dabei eine zuverlässige Versorgung der Elektronik, ohne dass dabei Kabel in das Elektronikschutzgehäuse hineingeführt werden müssen, welche im rauen Betriebsumfeld des Elektronikschutzgehäuses beschädigt werden oder brechen könnten. Von Vorteil ist dabei weiterhin die geringe Größe des Peltier-Elementes und die Vermeidung von beweglichen Bauteilen, welche einem Verschleiß ausgesetzt werden könnten. Dies ermöglicht insbesondere, auf elektrische Versorgungskabel, welche von außerhalb des Elektronikschutzgehäuses in dieses hinein geführt werden, zu verzichten und die Kommunikation mit der Elektronik drahtlos vorzunehmen.

Bei einer weiteren vorteilhaften Ausgestaltung der Erfindung weist das Elektronikschutzgehäuse eine drehbar in der zumindest einen Medienleitung angeordnete Turbine und Mittel zur Umwandlung einer Drehbewegung der Turbine in elektrische Energie auf, wobei die Elektronik mittels der Turbine und den Mitteln zur Umwandlung versorgbar ist.

Die Turbine kann beispielsweise ein einfaches Flügelrad aufweisen, welches aus der Strömungsbewegung des Kühlmediums eine Rotation des Flügelrates erzeugt. Diese Rotation kann anschließend von den Mitteln, beispielsweise einem Generator oder einem Dynamo, in elektrische Energie umgewandelt werden, welche zur Versorgung der Elektronik verwendet werden kann. Dies erlaubt wiederum die Elektronik ohne zusätzliche, in das Elektronikschutzgehäuse hinein geführte Kabel zu versorgen, was bei dem rauen Betriebsumfeld des Elektronikschutzgehäuses von Vorteil ist.

Bei einer weiteren vorteilhaften Ausgestaltung der Erfindung weist das Elektronikschutzgehäuse Mittel zur Umwandlung von mechanischer Energie des Elektronikschutzgehäuses in elektrische Energie zur Versorgung der Elektronik auf.

Das Elektronikschutzgehäuse kann beispielsweise zur Messung von physikalischen Beobachtungsgrößen, insbesondere bei einem Konverter oder bei einem Drehrohrofen, verwendet werden, wozu das Elektronikschutzgehäuse bewegt wird. Die Bewegung kann auch durch Stöße beim Abstellen von metallurgischen Gefäßen durch einen Hallenkran, durch das Rotieren des Konverters oder des Drehrohrofens oder beim Bewegen von Hüttenfahrzeugen erfolgen, welche jeweils mit dem Elektronikschutzgehäuse gekoppelt sind.

Diese Bewegung wird von den Mitteln zur Umwandlung von mechanischer Energie in elektrische Energie, dazu verwendet, elektrische Energie zu erzeugen, mit der die Elektronik versorgt werden kann. Zur Versorgung der Elektronik wird somit eine Methode des "Energy Harvesting" verwendet, wodurch wiederum auf zusätzliche, in das Elektronikschutzgehäuse hinein geführte Kabel verzichtet werden kann.

Bei einer weiteren vorteilhaften Ausgestaltung der Erfindung sind die Mittel zur Umwandlung von mechanischer Energie des Elektronikschutzgehäuses in elektrische Energie dabei als Piezoelement und/oder als dielektrisches Elastomer ausgeführt.

Sowohl das Piezoelement als auch das dielektrische Elastomer können dadurch, dass sie bewegt werden, elektrische Energie bereitstellen. Dabei kann die Bewegung in Form einer Vibration oder Translation oder dergleichen vorliegen. Hierzu kann beispielsweise eine Schwungmasse innerhalb des Elektronikschutzgehäuses vorgesehen werden, um die Effizienz der Versorgung des Elektronikschutzgehäuses weiter zu verbessern. Denkbar ist dabei auch, das Piezoelement und/oder das dielektrische Elastomer in der Nähe oder in direktem Kontakt mit einer gegebenenfalls vorgesehenen Medienleitung anzuordnen, so dass Vibrationen der Medienleitung zur Gewinnung der elektrischen Energie verwendet werden können.

Zusätzlich kann eine Pufferbatterie vorgesehen sein, die eine Versorgung der Elektronik auch dann sicherstellen kann, wenn aufgrund des Betriebszustands der Anlage keine ausreichende Stromversorgung über das Peltier-Element, die Turbine, den Generator und/oder das Piezoelement gegeben ist.

Bei einer weiteren vorteilhaften Ausgestaltung der Erfindung weist das Elektronikschutzgehäuse Mittel zum Erfassen eines Verschleißes des zumindest einen äußeren Gehäuseteils auf.

Durch das Erfassen des Verschleißes des zumindest einen äußeren Gehäuseteils ist es möglich, den zumindest einen äußeren Gehäuseteil rechtzeitig zu ersetzen und somit die Betriebsdauer des inneren Gehäuseteils und vor allem der Elektronik zu erhöhen. Dabei kann der zumindest eine äußere Gehäuseteil als Verschleißteil ausgelegt werden, welches kostengünstig ist und leicht ausgetauscht werden kann.

Der Verschleiß bzw. der Zustand des zumindest einen äußeren Gehäuseteils kann dabei an ein verbundenes Condition Monitoring System (CMS) gemeldet werden. Das Condition Monitoring System kann dann das Instandhaltungspersonal informieren, wenn sich der Zustand des äußeren Gehäuseteils rapide ändert bzw. ein kritischer Zustand eingetreten ist. Die Information des Personals kann beispielsweise über eine Anzeige auf einer Automatisierungs-Schnittstelle, wie einem Human-Machine-Interface (HMI), einem PC oder mobilen Endgerät, wie einem Tablet oder Smartphone, erfolgen.

Bei einer weiteren vorteilhaften Ausgestaltung der Erfindung umfassen die Mittel zum Erfassen eines Verschleißes dabei zumindest einen im zumindest einen äußeren Gehäuseteil angeordneten Draht, welcher mit einer Auswertungselektronik verbunden ist.

In den zumindest einen äußeren Gehäuseteil kann ein Draht oder mehrere Drähte eingebettet bzw. eingearbeitet werden, wobei die Enden des jeweiligen Drahtes beispielsweise über einen Kontaktstecker zur Auswertungselektronik geführt werden. Die Auswertelektronik ermittelt dann den Verschleiß bzw. den Zustand des zumindest einen äußeren Gehäuseteils, beispielsweise indem sie den Widerstand des Drahtes auswertet. Sobald die Verschleißschale bis zum Draht verschlissen ist, wird die Leitung unterbrochen, wobei diese Leitungsunterbrechung von der Auswertungselektronik insbesondere als "verschlissenes äußeres Gehäuseteil" gemeldet werden kann. Weiterhin ist denkbar, dass ein Halbleiter-Draht verwendet wird und der von der Temperatur des Drahtes und somit des zumindest einen äußeren Gehäuseteils abhängige Widerstand von der Auswertungselektronik erfasst wird, um wiederum den Verschleiß bzw. den Zustand des zumindest einen äußeren Gehäuseteils zu ermitteln.

Dabei können mehrere Drähte in verschiedenen Tiefen des zumindest einen äußeren Gehäuseteils eingebettet werden, um genauere Aussagen über den Verschleißzustand zu treffen. Beispielsweise können zumindest zwei Drähte in unterschiedlicher Tiefe vorgesehen sein, wobei eine Unterbrechung des äußeren Drahtes noch nicht als kritisch angesehen wird aber beispielsweise eine Nachbestellung des jeweiligen äußeren Gehäuseteils zur Folge hat. Wird auch der innere Draht unterbrochen, so ist der Zustand des jeweiligen äußeren Gehäuseteils kritisch und das äußere Gehäuseteil wird ausgetauscht.

Bei einer weiteren vorteilhaften Ausgestaltung der Erfindung umfassen die Mittel zum Erfassen eines Verschleißes dabei einen Magneten, eine Metallfolie, ein Metallstück und/oder ein RFID-Tag, welcher/welche/welches im zumindest einen äußeren Gehäuseteil angeordnet ist.

Der Verschleißzustand des zumindest einen äußeren Gehäuseteils kann auch durch das Einbetten von Magneten, Metallfolien/-stücken oder RFID-Tags in den zumindest einen äußeren Gehäuseteil ermittelt werden. Das jeweilige Messprinzip ist dann, dass der Magnet bzw. das Metallstück bzw. der RFID-Tag bei einem Verschleiß aus dem Empfangsbereich eines zugehörigen und geeigneten Detektors entfernt wird bzw. durch Verbrennung, Zerstörung, Abbrand, mechanische Verformung oder Zerfall unbrauchbar wird. Dies wird von der Auswertungselektronik erfasst und kann als "verschlissener äußerer Gehäuseteil" gemeldet werden. Dabei können wiederum mehrere solcher Elemente in verschiedener Tiefe des zumindest einen äußeren Gehäuseteils vorgesehen sein, um genauere Aussagen über den Verschleißzustand zu treffen.

Des Weiteren können die individuellen Charakteristiken der eingebetteten Mechanismen, wie zum Beispiel das Schwingungsverhalten oder eine eindeutige ID, auch zur eindeutigen Identifizierung des zumindest einen äußeren Gehäuseteils bzw. Elektronikschutzgehäuses herangezogen werden. Somit kann ein Aufstecken eines falschen oder eines nachgebauten Teils in Form eines Plagiats eindeutig erkannt werden, was zum einen Schutz vor Produktpiraterie und zum anderen eine hohe Qualität der verwendeten Teile sicherstellt.

Das vorgeschlagene System, welches das erläuterte Elektronikschutzgehäuse mit den Mitteln zum Erfassen eines Verschleißes sowie ein verbundenes Informationssystem umfasst, ermöglicht eine wirkungsvolle und effektive Überwachung des Elektronikschutzgehäuses. Beispielsweise kann das verbundene Informationssystem als Condition Monitoring System (CMS) ausgeführt sein, welches in ein umfassenderes IT-System eingebettet ist und insbesondere eine Alarmierung von Bedien/ Wartungspersonal bewirken kann und gegebenenfalls automatisch bei einem verschlissenen äußeren Gehäuseteil ein neues Äußeres Gehäuseteil nachbestellt.

Prinzipiell kann das erfindungsgemäße Elektronikschutzgehäuse bzw. die darin angeordneten Elektronik auch mittels eines Kabels mit Energie versorgt werden, wobei das Kabel von außen in das Elektronikschutzgehäuse hinein geführt wird. Denkbar ist dabei, das Kabel innerhalb der Medienleitungen zu führen.

Im Folgenden wird die Erfindung anhand der in den Figuren dargestellten Ausführungsbeispiele näher beschrieben und erläutert. Es zeigen:
- FIG 1: ein erstes Ausführungsbeispiel des erfindungsgemäßen Elektronikschutzgehäuses,
- FIG 2: ein zweites Ausführungsbeispiel, und
- FIG 3: ein drittes Ausführungsbeispiel.

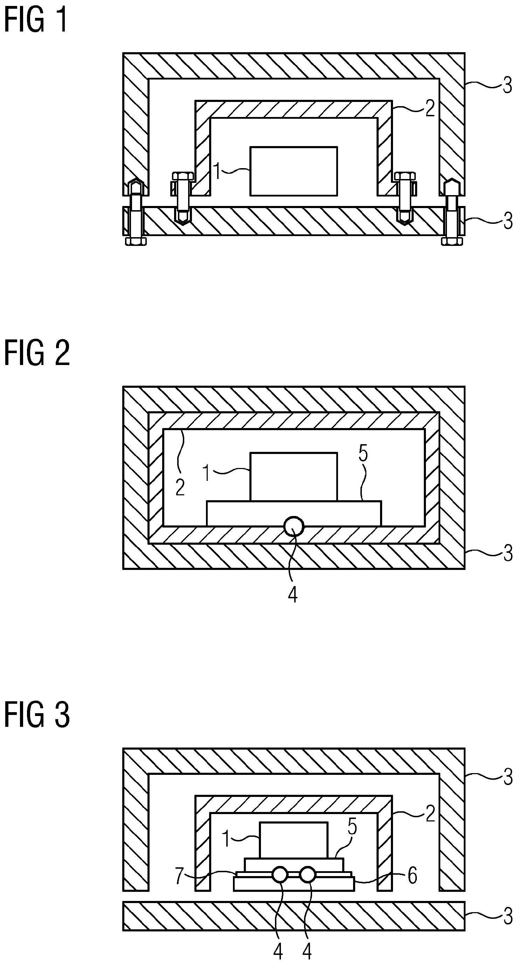

Figur 1 zeigt ein erstes Ausführungsbeispiel des erfindungsgemäßen Elektronikschutzgehäuses. Das Elektronikschutzgehäuse weist einen inneren Gehäuseteil 2, der eine Elektronik 1 teilweise umschließt, sowie einen äußeren Gehäuseteil 3 auf, welcher im Rahmen dieses Ausführungsbeispiels einen ersten Teil mit U-förmigem Querschnitt sowie einen zweiten als Platte ausgeführten Teil aufweist. Dabei sind der erste Teil und der zweite Teil des äußeren Gehäuseteils 3 mittels einer mechanisch lösbaren Schraubverbindung miteinander verbunden. Der zweistückig ausgeführte äußere Gehäuseteil 3 umschließt den inneren Gehäuseteil 2, wobei im inneren Gehäuseteil 2 eine Elektronik 1 angeordnet ist. Der innere Gehäuseteil 2 ist mittels einer mechanisch lösbaren Schraubverbindung am äußeren Gehäuseteil 3 befestigt.

Erfindungsgemäß weist der äußere Gehäuseteil 3 zumindest eine Lage mit einem nachwachsenden Rohstoff und der innere Gehäuseteil 2 zumindest eine Lage mit einem Kunststoff mit einer Temperaturbeständigkeit von mindestens bis 150 °C auf.

Figur 2 zeigt ein zweites Ausführungsbeispiel des erfindungsgemäßen Elektronikschutzgehäuses. Zum Schutz einer Elektronik 1 weist das Elektronikschutzgehäuse einen äußeren Gehäuseteil 3 mit einer Lage mit einem nachwachsenden Rohstoff und einen inneren Gehäuseteil 2 mit einer Lage mit einem Kunststoff mit einer Temperaturbeständigkeit von mindestens bis 150 °C auf. Der innere Gehäuseteil 2 umschließt die Elektronik 1 zumindest teilweise, wobei der äußere Gehäuseteil 3 den inneren Gehäuseteil 2 zumindest teilweise umschließt und die beiden mittels einer nicht näher dargestellten, mechanisch lösbaren Verbindung miteinander verbunden sind.

Die Elektronik 1 steht in thermischem Kontakt mit einem ersten Kühlkörper 5, wobei eine Medienleitung 4 durch das Elektronikschutzgehäuse hindurch führt und die Medienleitung 4 wiederum in thermischem Kontakt mit dem ersten Kühlkörper 5 steht. Beispielsweise kann die Medienleitung 4 innerhalb des Elektronikschutzgehäuses einen geraden Verlauf aufweisen, so dass die Medienleitung 4 auf der einen Seite des Elektronikschutzgehäuses in dieses eindringt und auf der gegenüberliegenden Seite dieses wieder verlässt.

Figur 3 zeigt ein drittes Ausführungsbeispiel des erfindungsgemäßen Elektronikschutzgehäuses. Im Elektronikschutzgehäuse ist eine Elektronik 1 angeordnet, welche in thermischem Kontakt mit einem ersten Kühlkörper 5 steht. Dabei ist eine Medienleitung 4 vorgesehen, an welche der erste Kühlkörper 5 Abwärme abgeben kann, indem der erste Kühlkörper 5 mit der Medienleitung 4 bzw. dem darin befindlichen Medium in thermischem Kontakt steht. Beispielsweise kann die Medienleitung innerhalb des Elektronikschutzgehäuses U-förmig ausgebildet sein, so dass sie auf einer Seite in das Elektronikschutzgehäuse eindringt, einen U-förmigen Bogen innerhalb des Elektronikschutzgehäuses aufweist und anschließend auf derselben Seite das Elektronikschutzgehäuse wieder verlässt.

Zusätzlich ist ein zweiter Kühlkörper 6 vorgesehen, welcher Abwärme ebenfalls an die Medienleitung 4 bzw. ein darin befindliches Medium abgeben kann. Dabei ist zwischen dem zweiten Kühlkörper 6 und dem ersten Kühlkörper 5 eine Isolierlage 7 vorgesehen, welche die beiden Kühlkörper voneinander thermisch isoliert, wobei im Rahmen des Ausführungsbeispiels die Medienleitung 4 in der Ebene der Isolierlage 7 vorgesehen ist. Die Isolierlage 7 bewirkt somit eine thermische Entkopplung des ersten Kühlkörper 5 vom zweiten Kühlkörper 7, so dass einerseits Abwärme der Elektronik 1 über den ersten Kühlkörper 5 lediglich an die Medienleitung 4 weitergegeben werden kann und nicht an den zweiten Kühlkörper 6. Andererseits verhindert die Isolierlage 7, dass Hitze von außerhalb des Elektronikschutzgehäuses über zumindest den äußeren Gehäuseteil 3 und den zweiten Kühlkörper 7 an den ersten Kühlkörper 5 und schließlich an die Elektronik 1 weitergegeben werden kann, da die Isolierlage 7 den zweiten Kühlkörper 6 vom ersten Kühlkörper 5 thermisch trennt.

Die Anordnung umfassend die Elektronik 1, den ersten Kühlkörper 5, die Isolierlage 7 und den zweiten Kühlkörper 6 wird durch einen inneren Gehäuseteil 2 mit einer Lage mit einem Kunststoff mit einer Temperaturbeständigkeit von mindestens bis 150 °C teilweise umschlossen, wobei der innere Gehäuseteil 2 von einem äußeren Gehäuseteil 3 umschlossen wird, welcher wie im ersten Ausführungsbeispiel zweiteilig ausgeführt ist und welcher eine Lage mit einem nachwachsenden Rohstoff aufweist. Dabei ist der äußere Gehäuseteil 3 am inneren Gehäuseteil 2 mittels einer nicht näher dargestellten mechanisch lösbaren Verbindung, beispielsweise einer Schraub- oder Klemmverbindung oder dergleichen, befestigt.

Bei jedem der Ausführungsbeispiele kann die Elektronik 1 beispielsweise mittels eines Peltier-Elementes, mittels einer in der Medienleitung 4 angeordneten Turbine und Mitteln zur Umwandlung der Drehbewegung der Turbine in elektrische Energie bzw. mittels eines Piezoelementes oder eines dielektrischen Elastomers mit elektrischer Energie versorgt werden.

Ferner kann das Elektronikschutzgehäuse Mittel zum Erfassen eines Verschleißes des äußeren Gehäuseteils 3 aufweisen, welche beispielsweise einen Draht umfassen, der zumindest teilweise im äußeren Gehäuseteil angeordnet ist und mit einer Auswertungselektronik verbunden ist. Auch können hierzu mehrere Drähte vorgesehen sein, welche im äußeren Gehäuseteil 3 in verschiedenen Tiefen bezüglich der äußeren Oberfläche des äußeren Gehäuseteils 3 verlaufen und somit einen Fortschritt des Verschleißes des äußeren Gehäuseteils 3 erfassbar machen. Die Mittel zum Erfassen des Verschleißes des äußeren Gehäuseteils 3 können auch einen Magneten, eine Metallfolie, ein Metallstück und/oder ein RFID-Tag umfassen, welcher/welche/welches im äußeren Gehäuseteil 3 angeordnet ist.

Zusammenfassend betrifft die Erfindung ein Elektronikschutzgehäuse zur Aufnahme einer Elektronik. Um ein Elektronikschutzgehäuse bereitzustellen, welches eine darin befindliche Elektronik zuverlässig vor Hitze oder heißen Flüssigkeiten bzw. Feststoffen schützt, wird vorgeschlagen, dass das Elektronikschutzgehäuse einen inneren Gehäuseteil, mittels dem die Elektronik zumindest teilweise umschließbar ist, und zumindest einen äußeren Gehäuseteil aufweist, der den inneren Gehäuseteil zumindest teilweise umschließt und der mittels einer mechanisch lösbaren Verbindung am inneren Gehäuseteil befestigbar ist, wobei der zumindest eine äußere Gehäuseteil zumindest eine Lage mit einem nachwachsenden Rohstoff aufweist, wobei der innere Gehäuseteil zumindest eine Lage mit einem Material mit einer Temperaturbeständigkeit von mindestens bis 150 °C aufweist.

## Patentansprüche

1. Elektronikschutzgehäuse zur Aufnahme einer Elektronik (1) und für einen dauerhaften Betrieb einer Elektronik zum Einsatz in der Nähe metallurgischer Gefäße undanderen Einsatzgebieten mit stark erhöhter Umgebungstemperatur,
aufweisend
- einen inneren Gehäuseteil (2), mittels dem die Elektronik (1) zumindest teilweise umschließbar ist, und
- zumindest einen äußeren Gehäuseteil (3) aufweist, der den inneren Gehäuseteil (2) zumindest teilweise umschließt und der mittels einer mechanisch lösbaren Verbindung am inneren Gehäuseteil (2) befestigbar ist,
wobei der zumindest eine äußere Gehäuseteil (3) zumindest eine Lage mit einem nachwachsenden Rohstoff aufweist,
wobei der innere Gehäuseteil (2) zumindest eine Lage mit einem Material mit einer Temperaturbeständigkeit von mindestens bis 150 °C aufweist.

2. Elektronikschutzgehäuse nach Anspruch 1,
wobei der zumindest eine innere Gehäuseteil (2) und der zumindest eine äußere Gehäuseteil (3) zumindest abschnittsweise für Funkwellen zur drahtlosen Kommunikation durchlässig sind.

3. Elektronikschutzgehäuse nach einem der vorhergehenden Ansprüche,
wobei innerhalb des äußeren Gehäuseteils und/oder innerhalb des inneren Gehäuseteils ein Schutzgas vorgesehen ist.

4. Elektronikschutzgehäuse nach einem der vorhergehenden Ansprüche,
wobei die zumindest eine Lage mit einem nachwachsenden Rohstoff Holz, Holzschaum Pappe, Karton, einen Holzfaserverbundwerkstoff oder ein Gemisch zumindest zweier dieser Stoffe aufweist.

5. Elektronikschutzgehäuse nach einem der vorhergehenden Ansprüche,
wobei die zumindest eine Lage mit dem Material mit einer Temperaturbeständigkeit von mindestens bis 150 °C Polytetrafluorethylen, Polyphenylensulfid, Silikon-Kautschuk, Polyimid, Ethylen-Propylen-Copolymer, Cyclo-Olefin-Copolymer, Polyetherimid, Polyethersulfon, Polyhydroxyalkanoat, Polyhydroxybutyrat, Polysulfon, oder ein Gemisch zumindest zweier dieser Stoffe aufweist.

6. Elektronikschutzgehäuse nach einem der vorhergehenden Ansprüche,
wobei zumindest eine Medienleitung (4) vorgesehen ist, welche von außerhalb des Elektronikschutzgehäuses in das innere Gehäuseteil (2) hinein führt und in welchem ein flüssiges oder gasförmiges Medium fließen kann.

7. Elektronikschutzgehäuse nach einem der vorhergehenden Ansprüche,
wobei das Elektronikschutzgehäuse einen ersten Kühlkörper (5) aufweist, mit welchem die Elektronik (1) thermisch verbindbar ist und an welchen die verbundene Elektronik (1) Abwärme abgeben kann.

8. Elektronikschutzgehäuse nach den Ansprüchen 5 und 6, wobei die zumindest eine Medienleitung (4) derart am ersten Kühlkörper (5) angeordnet ist, dass der erste Kühlkörper (5) Abwärme an das Medium abgeben kann.

9. Elektronikschutzgehäuse nach Anspruch 8,
wobei das Elektronikschutzgehäuse einen zweiten Kühlkörper (6) aufweist,
wobei die zumindest eine Medienleitung (4) derart am zweiten Kühlkörper (6) angeordnet ist, dass der zweite Kühlkörper (6) Abwärme an das Medium abgeben kann,
wobei zwischen dem ersten Kühlkörper (5) und dem zweiten Kühlkörper (6) eine Isolierlage (7) mit einem Kunststoff mit einer Temperaturbeständigkeit von mindestens bis 150 °C angeordnet ist.

10. Elektronikschutzgehäuse nach einem der Ansprüche 5-8, wobei das Elektronikschutzgehäuse ein Peltier-Element aufweist, mittels welchem die Elektronik (1) versorgbar ist, wobei eine Seite des Peltier-Elementes mit der zumindest einen Medienleitung (4) in thermischem Kontakt steht.

11. Elektronikschutzgehäuse nach einem der Ansprüche 5-9, wobei das Elektronikschutzgehäuse eine drehbar in der zumindest einen Medienleitung (4) angeordnete Turbine und Mittel zur Umwandlung einer Drehbewegung der Turbine in elektrische Energie aufweist,
wobei die Elektronik (1) mittels der Turbine und den Mitteln zur Umwandlung versorgbar ist.

12. Elektronikschutzgehäuse nach einem der vorhergehenden Ansprüche,
wobei das Elektronikschutzgehäuse Mittel zur Umwandlung von mechanischer Energie des Elektronikschutzgehäuses in elektrische Energie zur Versorgung der Elektronik (1) aufweist.

13. Elektronikschutzgehäuse nach Anspruch 12,
wobei die Mittel zur Umwandlung von mechanischer Energie des Elektronikschutzgehäuses in elektrische Energie als Piezoelement und/oder als dielektrisches Elastomer ausgeführt sind.

14. Elektronikschutzgehäuse nach einem der vorhergehenden Ansprüche,
wobei das Elektronikschutzgehäuse Mittel zum Erfassen eines Verschleißes des zumindest einen äußeren Gehäuseteils (3) aufweist.

15. Elektronikschutzgehäuse nach Anspruch 14,
wobei die Mittel zum Erfassen eines Verschleißes zumindest einen im zumindest einen äußeren Gehäuseteil (3) angeordneten Draht umfassen, welcher mit einer Auswertungselektronik verbunden ist.

16. Elektronikschutzgehäuse nach Anspruch 14 oder 15,
wobei die Mittel zum Erfassen eines Verschleißes einen Magneten, eine Metallfolie, ein Metallstück und/oder ein RFID-Tag umfassen, welcher/welche/welches im zumindest einen äußeren Gehäuseteil angeordnet ist.

17. System umfassend
- ein Elektronikschutzgehäuse nach einem der Ansprüche 14-16 und
- ein verbundenes Informationssystem, an welches die Mittel zum Erfassen eines Verschleißes Informationen zum Verschleiß des zumindest einen äußeren Gehäuseteils (3) übermitteln können,
wobei das verbundene Informationssystem insbesondere eine Alarmierung von Personal bewirken kann.

## Claims

1. Electronics protection housing for accommodating electronics (1), and for long-lasting operation of electronics for use in the vicinity of metallurgical vessels and in other fields of use having a significantly raised ambient temperature,
having
- an inner housing part (2), by means of which the electronics (1) can be at least partially enclosed, and
- at least one outer housing part (3), which at least partially encloses the inner housing part (2) and can be fastened to the inner housing part (2) by means of a mechanically removable connection,
wherein the at least one outer housing part (3) has at least one layer comprising a renewable raw material,
wherein the inner housing part (2) has at least one layer comprising a material having a temperature resistance of at least up to 150°C.

2. Electronics protection housing according to claim 1, wherein the at least one inner housing part (2) and the at least one outer housing part (3) are at least sectionally permeable to radio waves for the purpose of wireless communication.

3. Electronics protection housing according to one of the preceding claims,
wherein a protective gas is provided within the outer housing part and/or within the inner housing part.

4. Electronics protection housing according to one of the preceding claims,
wherein the at least one layer comprising a renewable raw material includes wood, wood foam paperboard, cardboard, a fibreboard composite material or a mixture of at least two of these materials.

5. Electronics protection housing according to one of the preceding claims,
wherein the at least one layer comprising the material having a temperature resistance of at least up to 150°C includes polytetrafluoroethylene, polyphenylene sulphide, silicone rubber, polyimide, ethylene propylene copolymer, cyclic olefin copolymer, polyetherimide, polyethersulfone, polyhydroxyalkanoate, polyhydroxybutyrate, polysulfone, or a mixture of at least two of these materials.

6. Electronics protection housing according to one of the preceding claims,
wherein provision is made for at least one medium line (4) which leads into the inner housing part (2) from outside the electronics protection housing and in which a liquid or gaseous medium can flow.

7. Electronics protection housing according to one of the preceding claims,
wherein the electronics protection housing has a first heat sink (5), to which the electronics (1) can be thermally connected and to which the connected electronics (1) can release waste heat.

8. Electronics protection housing according to the claims 5 and 6,
wherein the at least one medium line (4) is arranged at the first heat sink (5) in such a way that the first heat sink (5) can release waste heat to the medium.

9. Electronics protection housing according to claim 8, wherein the electronics protection housing has a second heat sink (6),
wherein the at least one medium line (4) is arranged at the second heat sink (6) in such a way that the second heat sink (6) can release waste heat to the medium,
wherein an insulation layer (7) comprising a synthetic material having a temperature resistance of at least up to 150°C is arranged between the first heat sink (5) and the second heat sink (6).

10. Electronics protection housing according to one of the claims 5 to 8,
wherein the electronics protection housing has a Peltier element by means of which the electronics (1) can be supplied, wherein one side of the Peltier element is in thermal contact with the at least one medium line (4).

11. Electronics protection housing according to one of the claims 5 to 9,
wherein the electronics protection housing has a turbine which is rotatably disposed in the at least one medium line (4), and means for converting a rotational movement of the turbine into electrical energy,
wherein the electronics (1) can be supplied by means of the turbine and the means for converting.

12. Electronics protection housing according to one of the preceding claims,
wherein the electronics protection housing has means for converting mechanical energy of the electronics protection housing into electrical energy for the purpose of supplying the electronics (1).

13. Electronics protection housing according to claim 12, wherein the means for converting mechanical energy of the electronics protection housing into electrical energy are embodied as a piezoelectric element and/or a dielectric elastomer.

14. Electronics protection housing according to one of the preceding claims,
wherein the electronics protection housing has means for registering wear of the at least one outer housing part (3).

15. Electronics protection housing according to claim 14, wherein the means for registering wear comprise at least one wire which is arranged in the at least one outer housing part (3) and is connected to analysis electronics.

16. Electronics protection housing according to claim 14 or 15,
wherein the means for registering wear comprise a magnet, a metal foil, a metal piece and/or an RFID tag which is arranged in the at least one outer housing part.

17. System comprising
- an electronics protection housing according to one of the claims 14 to 16,
and
- a connected information system, to which the means for registering wear can transmit information concerning the wear of the at least one outer housing part (3),
wherein the connected information system is able in particular to signal an alarm to personnel.

## Revendications

1. Boîtier de protection de système électronique destiné à recevoir un système électronique (1) et servant à assurer un fonctionnement durable d'un système électronique en vue d'une utilisation à proximité de récipients métallurgiques et dans d'autres applications à température ambiante très élevée, comprenant
- une partie de boîtier intérieure (2) qui permet d'entourer au moins en partie le système électronique (1), et
- au moins une partie de boîtier extérieure (3) qui entoure au moins en partie la partie de boîtier intérieure (2) et qui peut être fixée à la partie de boîtier intérieure (2) au moyen d'un dispositif d'assemblage mécaniquement démontable,
la ou les parties de boîtier extérieures (3) présentant au moins une couche contenant une matière première renouvelable, et la partie de boîtier intérieure (2) présentant au moins une couche contenant un matériau résistant à des températures allant au moins jusqu'à 150 °C.

2. Boîtier de protection de système électronique selon la revendication 1,
la ou les parties de boîtier intérieures (2) et la ou les parties de boîtier extérieures (3) laissant passer, au moins par zones, des ondes radio pour la communication sans fil.

3. Boîtier de protection de système électronique selon l'une des revendications précédentes,
un gaz protecteur étant prévu à l'intérieur de la partie de boîtier extérieure et/ou à l'intérieur de la partie de boîtier intérieure.

4. Boîtier de protection de système électronique selon l'une des revendications précédentes,
la ou les couches contenant une matière première renouvelable comprenant du bois, de la mousse de bois, du carton, un matériau composite à base de fibres de bois ou un mélange d'au moins deux de ces substances.

5. Boîtier de protection de système électronique selon l'une des revendications précédentes,
la ou les couches contenant le matériau résistant à des températures allant au moins jusqu'à 150 °C comprenant du polytétrafluoréthylène, du polysulfure de phénylène, du caoutchouc de silicone, du polyimide, un copolymère d'éthylène-propylène, un copolymère de cyclo-oléfine, du polyétherimide, du polyéthersulfone, du polyhydroxyalcanoate, du polyhydroxybutyrate, du polysulfone ou un mélange d'au moins deux de ces substances.

6. Boîtier de protection de système électronique selon l'une des revendications précédentes,
au moins une conduite de fluide (4) étant prévue, menant de l'extérieur du boîtier de protection de système électronique jusque dans la partie de boîtier intérieure (2) et dans laquelle un fluide liquide ou gazeux peut circuler.

7. Boîtier de protection de système électronique selon l'une des revendications précédentes,
le boîtier de protection de système électronique présentant un premier corps de refroidissement (5) auquel le système électronique (1) peut être relié thermiquement et auquel le système électronique (1) relié peut céder de la chaleur perdue.

8. Boîtier de protection de système électronique selon les revendications 5 et 6,
la ou les conduites de fluide (4) étant agencées sur le premier corps de refroidissement (5) de façon à ce que ce premier corps de refroidissement (5) puisse céder de la chaleur perdue au fluide.

9. Boîtier de protection de système électronique selon la revendication 8,
le boîtier de protection de système électronique présentant un second corps de refroidissement (6),
la ou les conduites de fluide (4) étant agencées sur le second corps de refroidissement (6) de façon à ce que ce second corps de refroidissement (6) puisse céder de la chaleur perdue au fluide,
entre le premier corps de refroidissement (5) et le second corps de refroidissement (6) étant prévue une couche isolante (7) contenant une matière synthétique résistant à des températures allant au moins jusqu'à 150 °C.

10. Boîtier de protection de système électronique selon l'une des revendications 5 à 8,
le boîtier de protection de système électronique présentant un élément Peltier apte à alimenter le système électronique (1), une face de l'élément Peltier étant en contact thermique avec la ou les conduites de fluide (4).

11. Boîtier de protection de système électronique selon l'une des revendications 5 à 9,
le boîtier de protection de système électronique présentant une turbine montée à rotation dans la ou les conduites de fluide (4) et des moyens permettant la conversion d'une rotation de la turbine en énergie électrique,
le système électronique (1) pouvant être alimenté par la turbine et les moyens de conversion.

12. Boîtier de protection de système électronique selon l'une des revendications précédentes,
le boîtier de protection de système électronique présentant des moyens permettant la conversion d'énergie mécanique du boîtier de protection de système électronique en énergie électrique pour l'alimentation du système électronique (1).

13. Boîtier de protection de système électronique selon la revendication 12,
les moyens permettant la conversion d'énergie mécanique du boîtier de protection de système électronique en énergie électrique se présentant sous forme d'éléments piézoélectriques et/ou sous forme d'élastomère diélectrique.

14. Boîtier de protection de système électronique selon l'une des revendications précédentes,
le boîtier de protection de système électronique présentant des moyens permettant de détecter une usure de la ou des parties de boîtier extérieures (3).

15. Boîtier de protection de système électronique selon la revendication 14,
les moyens de détection d'usure comprenant un fil disposé dans la ou les parties de boîtier extérieures (3) et qui est relié à un système électronique d'évaluation.

16. Boîtier de protection de système électronique selon la revendication 14 ou 15,
les moyens de détection d'usure comprenant un aimant, une feuille métallique, une pièce métallique et/ou une étiquette RFID, disposé(e) dans la ou les parties de boîtier extérieures.

17. Système comprenant
- un boîtier de protection de système électronique selon l'une des revendications 14 à 16 et
- un système d'information connecté auquel les moyens de détection d'usure peuvent transférer des informations relative à l'usure de la ou des parties de boîtier extérieures (3),
le système d'information pouvant notamment alerter le personnel.
